# EUROPÄISCHE PATENTANMELDUNG

(11) **EP 1 995 798 A2**
(43) Veröffentlichungstag der Anmeldung: **26.11.2008**
(21) Anmeldenummer: 08007957.7
(22) Anmeldetag: 24.04.2008
(51) Int. Cl.: H01L 39/24

(54) **Metallsubstrat für einen supraleitenden Dünnschicht-Bandleiter**

(30) Priorität: 24.05.2007 DE 102007024166
(71) Anmelder: Zenergy Power GmbH, 53359 Rheinbach (DE)
(72) Erfinder: Bäcker, Michael, Dr., 50670 Köln (DE)
(74) Vertreter: Prietsch, Reiner

(57) **Zusammenfassung**

Ein hochtemperatur-supraleitender Dünnschicht-Bandleiter, bestehend aus einem Metallsubstrat, einer darauf chemisch erzeugten Pufferschicht und einer darauf chemisch erzeugten, supraleitenden Beschichtung zeichnet sich durch eine hohe Texturierung der Pufferschicht aus, wenn das Metallsubstrat eine Oberflächenrauhigkeit rms < 50 nm, bevorzugt rms < 10 nm hat und die Pufferschicht unmittelbar, ohne zwischenschicht, kristallographisch unrotiert gegenüber der kristallinen Struktur des Metallsubstrats auf dessen Oberfläche aufgewachsen ist.

## Beschreibung

Die Erfindung betrifft einen hochtemperatur-supraleitenden Dünnschicht-Bandleiter und insbesondere dessen Metallsubstrat.

Hochtemperatur-supraleitende Dünnschicht-Bandleiter, kurz Coated Conductors, im Folgenden HTSL-CC, werden nach dem Stand der Technik ausgehend von einem texturierten Metallband hergestellt. Das Band, im Folgenden als Metallsubstrat bezeichnet, besteht aus einem vorzugsweise kubisch flächenzentriert kristallisierenden Metall (z.B. Ni, Cu, Au). Besonders geeignet ist Nickel, insbesondere Nickel mit einigen at-% Wolfram, vergl. DE 101 43 680 C1. Das texturierte Metallsubstrat wird mit einer Pufferschicht überzogen, die dazu dient, die Textur des Metallsubstrats auf die anschließend in bekannter Weise erzeugte, supraleitende Schicht zu übertragen. Für die Pufferschicht besonders geeignet sind Materialien, die eine geringe Gitterfehlanpassung sowohl zum Metallsubstrat als auch zu der kristallinen, hochtemperatur-supraleitenden Dünnschicht haben. Verwendet werden sowohl Materialien, die um 45 % rotiert auf dem Metallsubstrat aufwachsen, z.B. Lanthanzirkonat und andere Materialien mit Fluorid- oder Pyrochlorstruktur, als auch solche, die unrotiert aufwachsen und häufig Perowskitstruktur, z.B. Strontiumtitanat und Kalziumtitanat, oder Spinellstruktur, z.B. Strontiumruthenat und Neodymnickelat, haben

Aus "Effect of sulphur on cube texture formation in microalloyed nickel substrate tapes" (J. Eickemeyer et al.), Physica C 418 (2005) 9-15, "Growth of oxide seed layers on Ni and other technologically interesting metal substrates: issues related to formation and control of Sulfur superstructures for texture optimization" (C. Cantoni et al.), IEEE Transactions on Applied Superconductivity, Vol 13, No. 2, 2003 und weiteren Veröffentlichungen ist bekannt, dass eine sich normalerweise schon aus Verunreinigungen des Metallsubstrats bildende Chalkogenid-Überstruktur, insbesondere eine Schwefelüberstruktur, das epitaktische Wachstum von Pufferschichten begünstigt, die mittels einer physikalischen Methode, insbesondere durch Bedampfung des Metallsubstrats im Hochvakuum, abgeschieden werden. Deshalb wird im Stand der Technik das Ziel verfolgt, eine möglichst einheitliche Überstruktur mit hohem Bedeckungsgrad reproduzierbar zu erzeugen. Das physikalische Abscheiden der Pufferschicht ist jedoch ein kostenintensives Verfahren, das sich deshalb für die Herstellung von HTSL-CC oder auch nur deren Trägersubstrat nicht eignet.

Ebenfalls bekannt und wesentlich kostengünstiger ist die Herstellung von HTSL-CC mittels chemischer Beschichtungsverfahren (CSD/MOD), vgl. "Chemical solution deposition of <100> orientated SrTiO3 buffer layers on Ni substrates"; J.T. Dawley et al.; J. Mater. Res., Vol. 17, No.7, 2002. Gute Ergebnisse wurden auf Ni-Substrat mit Schwefelüberstruktur, auf welche man Lantanzirkonat aufwachsen lässt, erzielt, vgl. "Detailed investigations on La2Zr207 buffer layers for YBCO coated conductors prepared by chemical solution deposition" (K. Knoth et al.), Acta Materialica 55, 2007, 517-529.

vergleichbare Ergebnisse lassen sich jedoch mit Materialien, die nicht wie Lantanzirkonat um 45° rotiert, sondern unrotiert aufwachsen, z.B. Strontiumtitanat, nicht erzielen, uzw. auch dann nicht, wenn, wie an sich bekannt, ein Metallsubstrat mit geringer Oberflächenrauhigkeit verwendet wurde. Die aufgebrachten Strontiumtitanatschichten sind untexturiert oder nur schwach texturiert.

Der Erfindung liegt die Aufgabe zugrunde, einen auf chemischen Weg erzeugten HTSL-CC mit hochtexturierter Pufferschicht und insbesondere ein Metallsubstrat als Ausgangsmaterial hierfür zur Verfügung zu stellen.

Dies gelingt erfindungsgemäß durch das im Anspruch 1 angegebene Verfahren, bei dem man eine Überstruktur von der Oberfläche des Metallsubstrats vor dem Aufbringen der Pufferschicht entfernt.

Überraschenderweise hat sich nämlich gezeigt, dass eine Überstruktur, insbesondere eine Chalkogenid-Überstruktur und vor allem eine Schwefelüberstruktur, die bei mittels physikalischer Methoden erzeugten Pufferschichten und bei mittels chemischer Verfahren erzeugter Pufferschichten mit Fluorid- oder Pyrochloridstrutkur notwendig ist, im Falle einer chemischen Beschichtung mit unrotiert aufwachsenden Materialien wie solchen mit Perowskit- oder SpinellStruktur im Gegenteil die Ausbildung einer guten Textur verhindert.

Dieses Ergebnis ist sowohl von der Art der Entfernung der Überstruktur (mechanisches Polieren, Elektropolieren, Strahlen mit Strahlkörpern, z.B. Trockeneispartikeln oder selektives Ätzen mit schwach konzentrierter Salpetersäure) als auch von der Art der chemischen Beschichtungstechnologie, also Schleuderbeschichtung, Tauchbeschichtung oder Aufdrucken (slot-die-casting, ink-jet-printing) ebenso unabhängig wie von den Parametern des nachfolgenden Prozesses wie Glühtemperatur, Atmosphäre und Haltezeit.

Die besten Ergebnisse werden erhalten, wenn das Substrat im Zuge der Entfernung der Überstruktur auf eine Oberflächenrauhigkeit von weniger als 10 nm poliert wird.

Vorteilhaft wird für die Pufferschicht ein Material verwendet, dessen Gitterkonstante von derjenigen des Metallsubstrats weniger als ± 15 %, vorzugsweise weniger als ± 10 %, abweicht.

Im Weiteren bezieht sich die Erfindung auf die Verwendung eines biaxial texturierten Metallsubstrats mit den im Anspruch 8 angegebenen Merkmalen.

Die Pufferschicht kann insbesondere aus einem Material bestehen, dessen Gitterkonstante von derjenigen des Metallsubstrats um weniger als ± 15 %, bevorzugt weniger als ± 10 % abweicht. Insbesondere kommen jedoch Materialien in Betracht, deren Gitterkonstante sich von derjenigen des Metallsubstrats im Bereich von - 5 % bis + 15 % unterscheidet.

Die Erfindung stellt damit einen hochtemperatur-supraleitenden Dünnschicht-Bandleiter mit den Merkmalen des Anspruchs 10 zur Verfügung.

Besonders geeignet als Metallsubstrat ist Nickel oder eine Nickellegierung, die 85 at%, vorzugsweise 90 at% Nickel enthält. In diesem Fall eignen sich als Pufferschichtmaterialien vor allem Titanate, Ruthenate, Manganate, Nickelate und Cuprate, z.B. CaTi03, La2NiO4, Sr2RuO4, NdBa2Cu30x, Gd2Cu04, SrTiO3, Nd2CuO4, BaTiO3, (CaxSr1-x)TiO3 und (SrxBa1-x)TiO3.

### Beispiele:

Es wurden zwei verschiedene Ni (5 at% W) Metallsubstrate der Firma evico verwendet (Bandbreite 10 mm, Banddicke 80 µm). Diese Metallsubstrate wiesen beide eine Würfeltextur (001) mit einer Halbwertsbreite (FWHM) von 5,5° auf.

Beide Substrate wurden einer gleichen Walzumformung unterzogen und anschließend in einem batch-Glühprozess rekristallisiert. Durch langsame Abkühlung im batch-Glühprozess bildete sich auf beiden Substraten eine Schwefelüberstruktur aus.

Die Rauhigkeit der beiden Metallsubstrate wurde mittels AFM Mikroskop wie folgt gemessen:
Substrat 1: rms = 40 nm
Substrat 2: rms = 5 nm

Ein Teil des Substrats 1 wurde mechanisch poliert. Die Politur erfolgte auf einem Poliertisch (Fa. Struers) mit einer 0,1 µm Diamantsuspension. Die Rauhigkeit des Substrates konnte durch die Politur auf rms = 5 nm herabgesetzt werden. Durch das Polieren wurden alle anhaftenden Oberflächenschichten, also auch die Schwefelüberstruktur, entfernt. Da vor der Beschichtung keine Glühbehandlung mehr erfolgte, konnte diese Struktur auch nicht nachgebildet werden.

### Substrat 1 (poliert): rms = 5 nm

Alle Substrate wurden im Ultraschallbad zunächst mit Aceton und anschließend mit Isopropanol jeweils 5 min gereinigt.

Für die nachfolgenden Versuche standen also folgende Substrate zur Verfügung:
Substrat 1: rms = 40 nm; Schwefelüberstruktur
Substrat 2: rms = 5 nm; Schwefelüberstruktur
Substrat 3: rms = 5 nm; keine Schwefelüberstruktur, d.h. Substrat 1, jedoch poliert

Es wurden drei Beschichtungslösungen hergestellt:
Lösung 1: reines Strontiumtitanat (STO)
Lösung 2: Nb-dotiertes STO, elektrisch leitend
Lösung 3: Ca-dotiertes STO, bessere Gitteranpasssung zu Ni Substrat

Für Lösung 1 wurden 0,15 mol Ti(OCH2CH2CH2CH3)4 in Acetylaceton im mol-Verhältnis 1:2 gelöst. Anschließend wurden 0,15 mol Sr-Acetat in Eisessig im mol-Verhältnis 1:5 gelöst. Beide Lösungen wurden zusammengeführt und mit einer Mischung aus Eisessig und Methoxyethanol auf 500 ml so verdünnt, dass das Gesamtverhältnis von Eisessig und Methoxyethanol 1:2 betrug. Die Lösung wurde anschließend filtriert um möglicherweise aufgetretenen Niederschlag zu entfernen. Die ICP-OES Analyse (SPECTRO Genesis) ergab eine stöchiometrische 0,3 molare Lösung.

Für Lösung 2 wurden 0,1425 mol Ti(OCH2CH2CH2CH3)4 in Acetyl-aceton im mol-Verhältnis 1:2 gelöst und mit 0,0075 mol Nb(OCH2CH3)5 gelöst in Butanol versetzt. Alle weiteren Schritte wurden wie für Lösung 1 durchgeführt, so dass eine 0,3 molare Beschichtungslösung für ein Strontiumtitanat mit 5 % Nb-Dotierung erhalten wurde.

Lösung 3 wurde wie Lösung 1 hergestellt, jedoch wurde statt 0,15 mol Sr-Acetat eine Mischung aus 0,135 mol Sr-Acetat und 0,015 mol Ca-Acetat eingesetzt. Es wurde eine 0,3 molare Beschichtungslösung für ein Ca-substituiertes Strontiumtitanat erhalten.

Alle gereinigten Substrate wurden mit allen Lösungen wie folgt beschichtet:
Die gereinigten Substrate von 5 cm Länge wurden auf einem Spin-Coater bei 500/min zunächst mit einer um den Faktor 6 verdünnten Beschichtungslösung beschichtet. Die Verdünnung erfolgte mit einer Mischung 2:1 aus Eisessig und Methoxyethanol. Anschließend erfolgte die Temperaturbehandlung unter 10 % H2 in N2 bei einer Temperatur von 800°C für 5 min. Durch die Verdünnung der Lösungen entstand im ersten Beschichtungsschritt ein so genannter seed-layer, d.h. eine nicht zusammenhängende Schicht (Bedeckung zwischen 20-80%), deren Inseln als Kristallisationskeime für nachfolgende Schichten wirken.

Unter den gleichen Bedingungen erfolgten zwei weitere Beschichtungen und Temperaturbehandlungen, jedoch mit unverdünnten Lösungen. Die resultierende Gesamtschichtdicke lag nach 3 Beschichtungen bei jeweils 250 nm. Die Schichtdicke wurde mittels eines Profilmeters über eine Schichtkante gemessen.

Versuche zur Variation der Glühtemperatur zwischen 750 und 900°, sowie der Glühatmosphäre zwischen 5-15 % H2 in N2 zeigten keinen signifikanten Einfluss auf das Versuchsergebnis. Bei einer Verwendung einer Tauchbeschichtungsanlage (dip coating) müssen alle Lösungen bei einer Beschichtungsgeschwindigkeit von 10 m/h um den Faktor 2 verdünnt werden um gleiche Ergebnisse zu erreichen. Höhere Tauchgeschwindigkeiten verlangen geringere Verdünnungen.

Für die 3 Substrate wurden folgende Ergebnisse für Lösung 1 (STO) beobachtet:

Als Maß für die Textur wurde das Verhältnis I von 200 (32°) zu 110 (47°) Reflex verwendet Ab einem Wert von ca. 5 kann von einer guten Textur ausgegangen werden.

| | Substrat 1 | Substrat 2 | Substrat 3 |
|---|---|---|---|
| I(200)/I(110) | 1 | 2 | 6 |

Ergebnis:
Die Entfernung der Schwefelüberstruktur bei Substrat 3 verbessert bei gleicher Oberflächenrauhigkeit wie Substrat 2 die Textur der Pufferschicht um das Dreifache.

## Patentansprüche

1. Verfahren zum Bearbeiten eines biaxial texturierten Metallsubstrats als Ausgangsmaterial für einen hochtemperatur-supraleitenden Dünnschicht-Bandleiter (HTSL-CC), bestehend aus dem Metallsubstrat, einer darauf chemisch erzeugten, kristallografisch unrotiert gegenüber dem Metallsubstrat aufgewachsenen Pufferschicht und darauf einer chemisch erzeugten supraleitenden Beschichtung, **dadurch gekennzeichnet, dass** eine Überstruktur des Metallsubstrats vor dem Erzeugen der Pufferschicht entfernt wird.

2. Verfahen nach Anspruch 1, **dadurch gekennzeichnet, dass** eine Chalkogenid-Überstruktur entfernt wird.

3. Verfahren nach Anspruch 1 oder 2, **dadurch gekennzeichnet,dass** das Metallsubstrat auf eine Oberflächenrauhigkeit rms < 50 nm, vorzugsweise rms < 20 nm, besonders bevorzugt rms < 10 nm, hin bearbeitet wird.

4. Verfahren nach einem der Ansprüche 1 bis 3, **dadurch gekennzeichnet, dass** die Überstruktur durch Polieren entfernt wird.

5. Verfahren nach einem der Ansprüche 1 bis 4, **dadurch gekennzeichnet, dass** für die Pufferschicht ein Material verwendet wird, dessen Gitterkonstante von derjenigen des Metallsubstrats um weniger als ± 15 %, vorzugsweise weniger als ± 10 %, abweicht.

6. Verfahren nach einem der Ansprüche 1 bis 5, **dadurch gekennzeichnet, dass** das Metallsubstrat nach dem Entfernen der Überstruktur gereinigt wird.

7. Verfahren nach Anspruch 6, **dadurch gekennzeichnet, dass** das Metallsubstrat im Ultraschallbad gereinigt wird.

8. Verfahren nach Anspruch 6 oder 7, **dadurch gekennzeichnet, dass** das Metallsubstrat entfettet wird, insbesondere unter Verwendung von Aceton und Isopropanol.

9. Verwendung eines biaxial texturierten Metallsubstrats ohne Überstruktur und mit einer Oberflächenrauhigkeit rms < 50 nm, vorzugsweise rms < 20 nm, besonders bevorzugt rms < 10 nm, als Ausgangsmaterial für einen hochtemperatur-supraleitenden Dünnschicht-Bandleiter (HTSL-CC), bestehend aus einem Metallsubstrat, einer darauf chemisch erzeugten, kristallografisch unrotiert gegenüber dem Metallsubstrat aufgewachsenen Pufferschicht und darauf einer chemisch erzeugten supraleitenden Beschichtung.

10. Verwendung eines Metallsubstrats gemäß Anspruch 9, wobei die Pufferschicht aus einem Material besteht, dessen Gitterkonstante von derjenigen des Metallsubstrats um weniger als ± 15 %, bevorzugt weniger als ± 10 %, abweicht.

11. Hochtemperatur-supraleitender Dünnschicht-Bandleiter (HTSL-CC), bestehend aus einem Metallsubstrat, einer darauf chemisch erzeugten Pufferschicht und darauf einer chemisch erzeugten, supraleitenden Beschichtung, **dadurch gekennzeichnet, dass** das Metallsubstrat eine Oberflächenrauhigkeit rms < 50 nm, vorzugsweise rms < 20 nm, besonders bevorzugt rms < 10 nm, hat und dass die Pufferschicht unmittelbar, ohne Zwischenschicht, kristallografisch unrotiert gegenüber der kristallinen Struktur des Metallsubstrats auf dessen Oberfläche aufgewachsen ist.

12. Metallsubstrat für einen der vorhergehenden Ansprüche, **dadurch gekennzeichnet, dass** es mindestens 85 at%, vorzugsweise 90 at% Nickel enthält.
